# FASCICULE DE BREVET EUROPEEN

(11) **EP 1 355 523 B1**
(45) Date de publication et mention de la délivrance du brevet: **21.04.2010**
(21) Numéro de dépôt: 03100955.8
(22) Date de dépôt: 09.04.2003
(51) Int. Cl.: H05K 7/14

(54) **Dispositif d'automatisation modulaire.**
Modulares Automatisierungsgerät
Modular automation device

(30) Priorité: 15.04.2002 FR 0204833
(43) Date de publication de la demande: 22.10.2003
(73) Titulaire: Schneider Automation Inc., North Andover, Massachusetts 01845 (US)
(72) Inventeur: Bet, Robert, 21370, Velars s/Ouche (FR); Girard, Michel, 21910, Corcelles-Les-Citeaux (FR); Rix, Philippe, 21240 Talant (FR)
(74) Mandataire: Dufresne, Thierry

(56) Documents cités:
- DE-A- 4 223 193
- FR-A- 2 567 304
- US-A1- 2001 053 619

## Description

La présente invention concerne un dispositif d'automatisation modulaire associé à un îlot d'automatisme, ce dispositif comprenant un groupe principal de modules juxtaposés sur un support, lequel groupe présente un organe de commande, tel qu'un coupleur de bus, un module d'alimentation apte à distribuer au moins une tension d'alimentation nécessaire aux organes d'automatisme de l'îlot, et plusieurs modules fonctionnels d'entrée et/ou de sortie auxquels se raccordent les organes d'automatisme.

Le coupleur de bus est apte à acheminer des signaux de contrôle-commande entre un bus externe, notamment un bus de terrain, de liaison avec un système de commande et/ou de surveillance tel qu'un automate programmable. Le dispositif d'automatisation doit d'autre part assurer l'alimentation des circuits électroniques des divers modules sous une tension de bas niveau, typiquement 5V ou 24Vdc. II doit aussi fournir au moins une tension d'alimentation, désignée par la suite comme tension "applicative", pour des organes applicatifs d'automatisme, tels que des capteurs et actionneurs, cette tension étant typiquement de 24V ou 48Vdc (courant continu) ou de 110V ou 250Vac (courant alternatif). Les modules fonctionnels d'entrée-sortie communiquent les signaux et tensions applicatives aux capteurs et actionneurs.

II existe, entre les modules, une liaison dite de signaux, pour acheminer les signaux de contrôle et au moins une tension de fonctionnement des modules, et une liaison dite d'alimentation, acheminant les tensions d'alimentation applicatives, nécessaires au fonctionnement des organes applicatifs. Ces liaisons constituent des bus internes réalisés soit en fond de bac ou dans un socle, soit au moyen d'embases individuelles interconnectées latéralement.

De tels dispositifs sont bien connus, notamment d'après les documents EP 661 915, EP 677 986 et EP 1 022 809. L'agencement modulaire des dispositifs connus permet d'étendre facilement leur capacité d'action par l'adjonction de modules. Dans une installation automatisée ou une machine, il s'avère cependant parfois nécessaire de distinguer diverses zones, différenciées par exemple par leur fonction ou leur relatif éloignement, en affectant à une zone principale un groupe principal de modules et à une zone secondaire au moins un groupe secondaire de modules.
Mais il faut alors prévoir pour chaque groupe secondaire un coupleur de bus, ce qui est coûteux.

L'invention a notamment pour but d'adapter un dispositif d'automatisation du type décrit pour éviter la présence d'un coupleur de bus dans un groupe secondaire de modules relié au groupe principal.

Selon l'invention qui est bien définie dans la revendication 1, le dispositif comprend au moins un groupe secondaire de modules associé à une zone secondaire de l'îlot et présentant un module de tête, ainsi qu'une première et une deuxième liaison prolongeant celles du groupe principal,
- un câble de liaison, associé à la première liaison et apte à acheminer les signaux de contrôle-commande et une tension d'alimentation des modules, est connecté à un module terminal du groupe principal et au module de tête du groupe secondaire, lequel module de tête du groupe secondaire possède des moyens aptes à acheminer de façon immune vers le (ou du) groupe secondaire les signaux de contrôle-commande et à acheminer vers le groupe secondaire une tension d'alimentation des modules.

Le groupe principal de modules comprend de préférence au moins un module d'alimentation des circuits électroniques des modules situés en aval, ce module possédant des moyens convertisseurs de tension aptes à rétablir à son niveau nominal une tension d'alimentation basse de la première liaison à partir d'une tension d'alimentation haute de cette même liaison. Le module de tête du groupe secondaire peut également posséder de tels moyens convertisseurs de tension.

Un module d'alimentation connecté à une source de tension externe et apte à distribuer au moins une tension d'alimentation nécessaire aux organes d'automatisme peut être disposé en adjacence au module de tête du groupe secondaire.

Le module terminal du groupe principal permet avantageusement d'appliquer, au moyen d'au moins un conducteur d'alimentation distinct du câble de liaison, les tensions de la deuxième liaison de bus à des organes d'automatisme non gérés par la première liaison de bus. A cet effet, le module terminal peut présenter un bornier prévu pour connecter les conducteurs d'alimentation de l'organe d'application et cloisonné, notamment au moyen d'un volet mobile, pour séparer le câble de liaison des conducteurs d'alimentation.

La description va être faite ci-après d'un mode de réalisation non limitatif de l'invention, en regard des dessins annexés.
La figure 1 représente schématiquement de face un dispositif d'automatisation conforme à l'invention.
La figure 2 montre un détail de la liaison de signaux assurée entre les modules du dispositif.
La figure 3 montre un détail de conversion de tension propre à la liaison de signaux.
La figure 4 représente en perspective un module d'entrée-sortie du dispositif.
La figure 5 montre en perspective arrière un bornier d'un module terminal du dispositif.
La figure 6 illustre un détail de ce module.
La figure 7 est une perspective éclatée du bornier de la figure 5.
La figure 8 illustre un détail de connexion du câble de liaison.

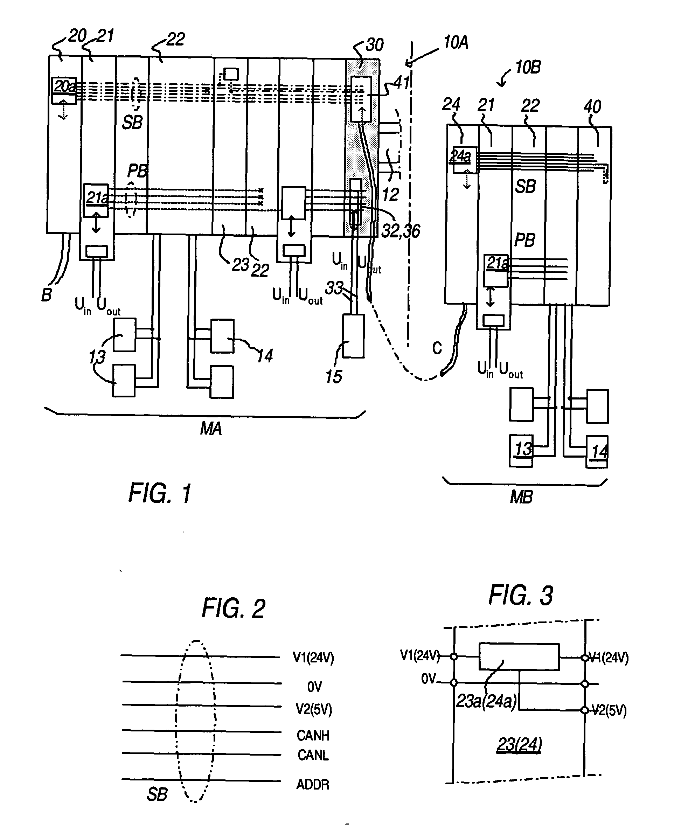

Le dispositif illustré sur les figures comprend un groupe principal 10A de modules électroniques destinés à être emboîtés et encliquetés dans des embases individuelles 11 (voir figure 2) elles-mêmes encliquetables en adjacence par tous moyens usuels sur un support, par exemple un profilé chapeau 12. Le groupe de modules 10A est associé à une zone MA d'un îlot d'automatisation, par exemple une machine ou partie de machine, et régit le flux de données vers l'îlot ou en provenance de l'îlot. De plus, par le groupe de modules 10A transite l'alimentation des organes d'automatisme - capteurs 13 ou actionneurs 14 - associés à la zone MA.

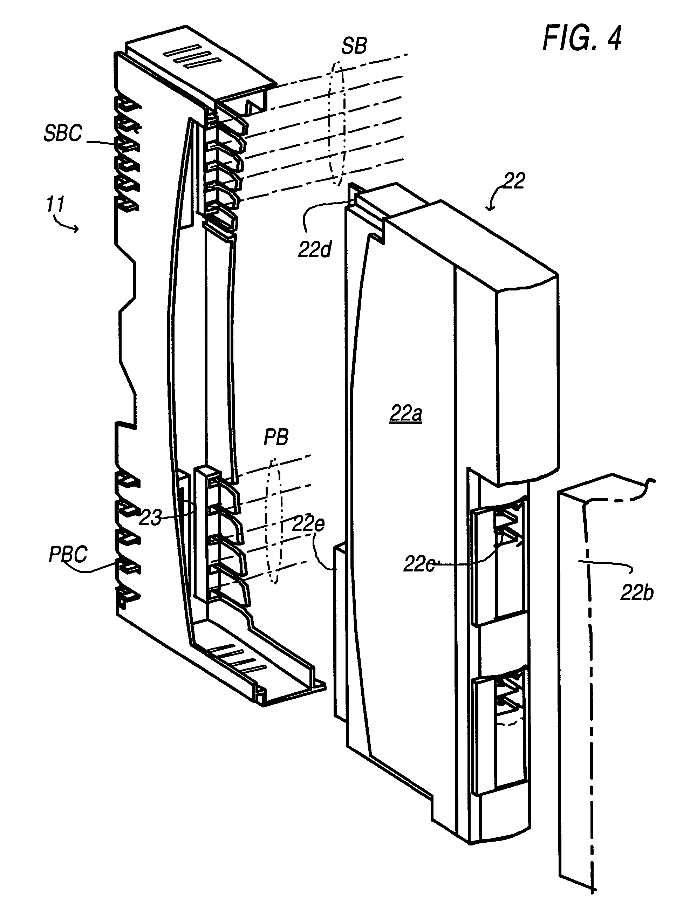

A cet effet, le groupe de modules comprend une liaison SB affectée aux signaux et à l'alimentation des circuits des modules et une liaison PB affectée à l'alimentation des organes d'automatisme pour leur transmettre les tensions requises par l'îlot. Les embases 11 sont interconnectées latéralement par des contacts coopérants SBC et PBC de manière à assurer la continuité de ces liaisons. Les liaisons SB,PB sont situées en hauteur à des niveaux différents, mais en profondeur au même niveau (voir figure 4).

Le groupe 10A comprend en tête un organe de commande constitué ici par un coupleur 20 auquel se raccorde un bus externe de terrain B - par exemple de type CA-NOpen, DeviceNet, Ethernet, Fipl/O, Modbus, Profibus ou autre - relié à un automate programmable ou autre organe de contrôle / commande. En variante, l'organe de commande peut être une unité centrale.

Le groupe 10A comporte aussi au moins un module d'alimentation 21 apte à fournir aux capteurs 13 et actionneurs 14, à partir de tensions externes Uᵢₙ et/ou Uₒᵤₜ, les tensions d'alimentation qui leur sont nécessaires, ainsi que des modules 22 d'entrée/sortie de diverses tailles reliés aux organes 13,14 et un module terminal 30. Les modules 22 sont munis de circuits imprimés et connecteurs appropriés et il est prévu un module 23 garantissant le niveau des tensions d'alimentation des circuits électroniques des modules 22. Ce module permet, lorsqu'une chute excessive de tension risque de se manifester pour l'une des tensions de la liaison SB, de rétablir la tension considérée à son niveau nominal à partir de la plus élevée des tensions de la liaison SB.

La figure 2 montre un exemple de composition de la liaison bas niveau SB : une ligne de tension "haute" V1 (24V), une ligne 0V, une ligne de tension "basse" V2 (5V), et des lignes de signaux dépendant du type de bus adopté ; ici, le bus interne étant de type CAN, il s'agit de lignes CANH et CANL et d'une ligne d'adressage ADDR. Le coupleur 20 comprend des moyens d'interfaçage et de liaison 20a qui couplent les lignes de la liaison SB à celles du bus B.

Le module d'alimentation de puissance 21 comprend des moyens 21 a de liaison et conversion des tensions de source externe Uᵢₙ (tension des capteurs),Uₒᵤₜ (tension des actionneurs) avec les tensions souhaitées sur la liaison PB : par exemple 24 ou 48V do pour les capteurs et 24Vdc, 48Vdc, 110 Vac ou 250Vac pour les actionneurs. Les tensions Uᵢₙ,Uₒᵤₜ disponibles sont sécurisées ou non sécurisées en fonction de l'îlot d'automatisme considéré. Le module d'alimentation 21 assure la mise à la terre du groupe de modules.

La tension V1 est moins affectée par la longueur du chemin de transmisssion que la tension V2 ; il est donc intéressant d'utiliser la tension V1 (24V) pour régénérer la tension V2 (5V). Ainsi, comme indiqué figure 3, le module 23 comporte un circuit convertisseur 23a qui convertit la tension 24Vdc en tension 5Vdc pour assurer que les modules 22 situés en aval du module 23 seront alimentés convenablement en tension 5V.

Comme indiqué figure 4, un module 22 d'entrée/sortie comprend un boîtier 22a encliqueté de manière amovible sur une embase 11. A l'avant du boîtier 22a peut être fixé un bornier 22b de raccordement externe aux organes d'automatisme 13,14 à surveiller ou commander, des connexions 22c étant prévues à l'avant du boîtier pour coopérer avec des connexions complémentaires du bornier 22b. Des éléments de connexion ou contacts 22d,22e sont disposés vers l'arrière du boîtier pour se connecter à des pièces de connexion appropriées elles-mêmes reliées à la liaison bas niveau SB et respectivement à la liaison de puissance PB. II convient de noter que chaque module 22 peut être enlevé du groupe en fonctionnement sans altérer la continuité des bus, ni le fonctionnement des modules situés en aval (réalisation "hotswap").

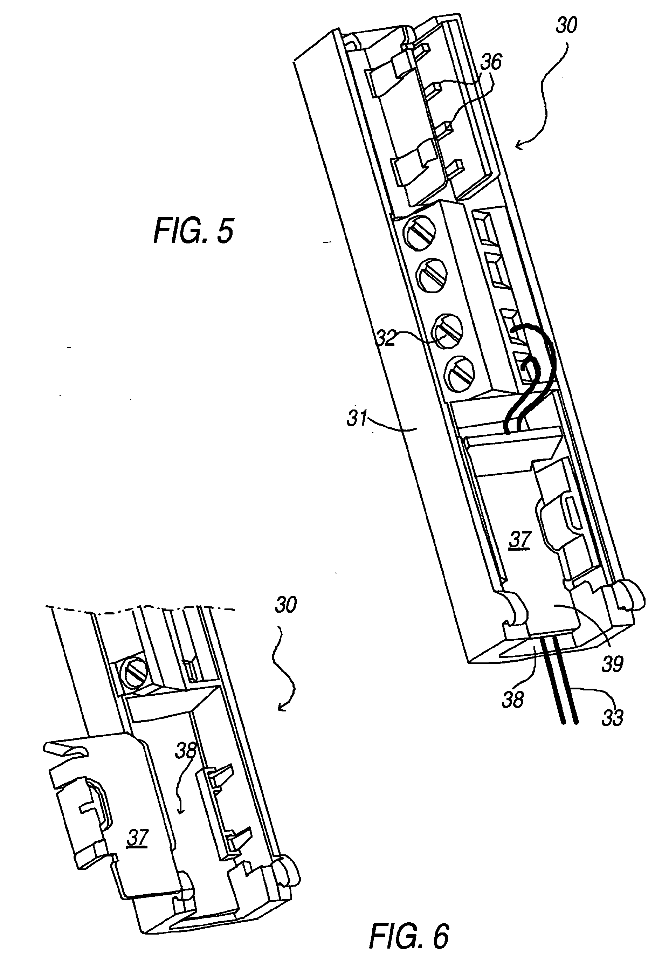

Les figures 5 à 7 montrent plus en détail, vu de derrière, un bornier 31 appartenant à un module terminal 30, le terme "terminal" signifiant situé à l'extrémité aval (à l'opposé du coupleur) du groupe principal. Le module terminal 30 permet de transmettre au module de tête 24 d'un groupe secondaire (ou aval) 10B de modules associé à une autre zone MB de l'îlot, ou à un sous-îlot, les signaux et de préférence la tension la plus élevée de la liaison SB, sans que ce groupe ne nécessite la présence d'un nouveau coupleur 20. Un tel groupe secondaire 10B est représenté sur la figure 1. II comprend successivement, outre le module de tête 24, un module d'alimentation de puissance 21, des modules 22 d'entrée et/ou de sortie et un module terminal 40 qui assure la terminaison voulue des lignes de bus, par exemple un bouclage résistif. Comme pour les modules du groupe 10A, ceux 24,21,22 et 40 du groupe 10B sont montés sur des embases 11 assurant la continuité des liaisons SB et PB. En l'absence de groupe secondaire 10B, on monte à l'extrémité du groupe principal 10A un module 40 du type indiqué pour le groupe 10B.

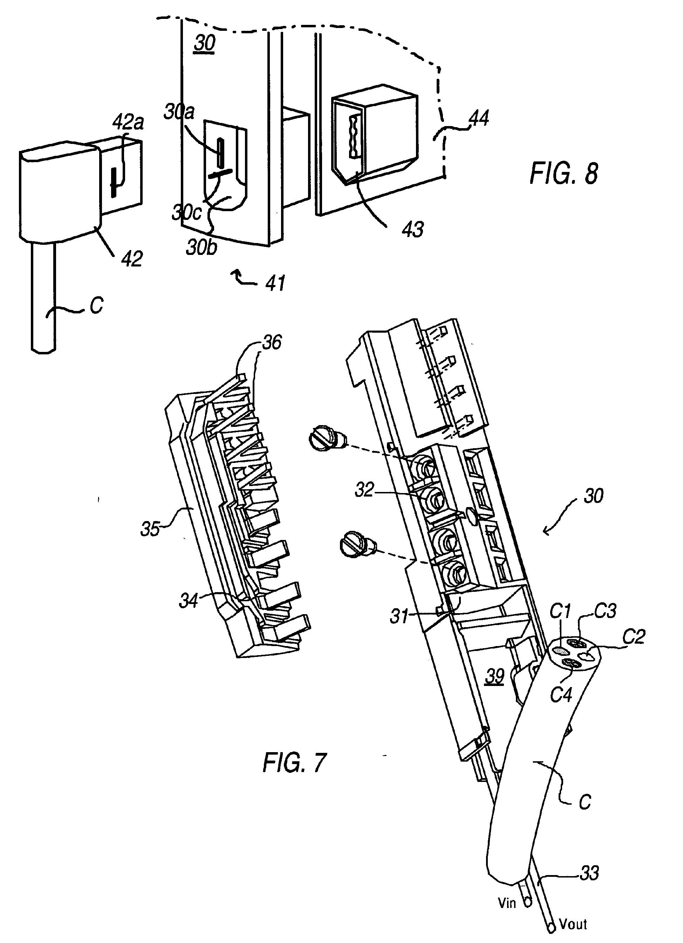

La connexion de liaison SB entre les groupes 10A et 10B utilise un câble C immunisé aux perturbations. Le câble C est connecté à une première extrémité à la liaison SB du groupe 10A dans son module terminal 30 (connecteur 41 indiqué figure 1) et à une deuxième extrémité à la liaison SB propre au groupe 10B dans son module de tête 24. Le câble C est par exemple du type IEEE 1394 et, comme on le voit figure 7, comporte un fil C1 acheminant la tension V1 la plus élevée de la liaison SB, un fil C2 de retour de tension 0V, et deux paires C3,C4 blindées et indépendantes formées de fils torsadés pour acheminer les signaux de bus. Le module de tête 24 comporte des moyens 24a, analogues aux moyens 23a du module 23, propres à convertir la "forte" tension V1 (24V), transmise via le câble C, en "faible" tension V2 (5V). II en résulte que la liaison SB du groupe 10B dispose d'une "faible" tension V2 de niveau garanti.

Le module terminal 30 permet aussi d'alimenter avec les tensions de la liaison PB des organes d'automatisme 15, capteurs ou actionneurs, non gérés par la liaison SB. II présente ainsi un bornier 31 doté de bornes 32 pour connecter les conducteurs 33 aux organes 15 ; les bornes 32 sont elles-mêmes reliées par des conducteurs internes 34 montés en peigne dans un support 35 à des broches de connexion 36 qui coopèrent avec un connecteur non représenté du circuit imprimé du module 30. Le bornier est monté de manière pivotante sur le boîtier du module 30 et il est compartimenté à sa partie basse par un volet pivotant 37 qui sépare un passage avant 38 (arrière sur les figures 5 à 7) d'un logement arrière 39 (avant sur les figures 5 à 7).

En position ouverte (figure 6), le volet 37 permet de faire passer dans le passage 38 les conducteurs 33 connectés aux bornes 32 ; quand il est refermé (figures 5 et 7), le volet 37 permet de laisser un espace substantiel pour le passage du câble C. II convient de remarquer que le câble C occupe un volume assez important, du fait de sa constitution et de ses propriétés d'immunité aux perturbations. L'agencement indiqué du module terminal permet d'assurer aisément une liaison de signal avec le connecteur 41 situé en haut du module et une liaison de puissance avec les bornes 32 situées à la partie basse du module, grâce au compartimentage de l'extrémité inférieure du bornier 31.

Comme on le voit figure 8, le raccord 41 du câble de liaison C présente une partie femelle 42 doté de formes 42a destinées à coopérer avec des formes respectives 30a prévues dans un canal d'engagement 30b du module terminal 30. De la sorte, la partie femelle 42 du connecteur peut se connecter à la partie mâle 43 du connecteur soudée à une carte à circuit électronique 44 en éliminant le risque d'endommagement des soudures par les vibrations entre raccord 41 et module 30. Des formes 30c de guidage de la partie femelle 42 sont aussi prévues dans le canal 30b.

## Revendications

1. Dispositif d'automatisation comprenant un ensemble modulaire associé à un îlot d'automatisme et comprenant un groupe principal (10A) de modules juxtaposés sur un support associé à une zone principale de l'ilôt, le groupe principal comportant un organe de commande (20) apte à acheminer des signaux de contrôle-commande, un module d'alimentation (21) apte à distribuer au moins une tension d'alimentation (Un, Uₒᵤₜ) pour des organes d'automatisme, plusieurs modules fonctionnels (22), avec, entre les modules, une première liaison (SB) qui achemine les signaux de contrôle et au moins une tension d'alimentation des modules et une deuxième liaison (PB) qui achemine les tensions d'alimentation des organes d'automatisme, et un module terminal (30),
***caractérisé par le fait que** :*
- le dispositif comprend au moins un groupe secondaire de modules (10B) associé à une zone secondaire de l'îlot et présentant un module de tête (24), ainsi qu'une première et une deuxième liaison (SB,PB) prolongeant celles du groupe principal (10A),
- un câble de liaison (C) associé à la première liaison (SB) et apte à acheminer de façon immune les signaux de contrôle-commande et une tension d'alimentation (V1) des modules, le câble étant connecté au module terminal (30) du groupe principal et au module de tête (24) du groupe secondaire (10B).

2. Dispositif selon la revendication 1, **caractérisé par le fait que** le groupe principal (10A) comprend au moins un module d'alimentation (23) des circuits électroniques des modules situés en aval, ce module possédant des moyens (23a) convertisseurs de tension aptes à rétablir à son niveau nominal une tension d'alimentation basse (V2) de la première liaison (SB) à partir d'une tension d'alimentation haute (V1) de cette même liaison.

3. Dispositif selon la revendication 1 ou 2, **caractérisé par le fait que** le module de tête (24) du groupe secondaire (10B) possède des moyens (24a) convertisseurs de tension aptes à rétablir à son niveau nominal une tension d'alimentation basse (V2) de la première liaison (SB) à partir d'une tension d'alimentation haute (V1) de cette même liaison.

4. Dispositif selon la revendication 1, **caractérisé par le fait qu'**un module d'alimentation (21) connecté à une source de tension externe et apte à distribuer au moins une tension d'alimentation (Uᵢₙ, Uₒᵤₜ) pour des organes d'automatisme est disposé adjacent au module de tête (24) du groupe secondaire (10B).

5. Dispositif selon la revendication 1, **caractérisé par le fait que** le module terminal (30) du groupe principal (10A) permet d'appliquer, au moyen d'au moins un conducteur d'alimentation (33) distinct du câble (C), les tensions de la deuxième liaison de bus (PB) à des organes d'automatisme (15) non gérés par la première liaison de bus (SB).

6. Dispositif selon la revendication 5, **caractérisé par le fait que** le module terminal (30) du groupe principal (10A) présente un bornier (31) pourvu de bornes (32) pour les conducteurs d'alimentation (33) des organes d'automatisme et cloisonné pour séparer le câble de liaison (C) des conducteurs (33).

7. Dispositif selon la revendication 6, **caractérisé par le fait que** le bornier (31) est cloisonné au moyen d'un volet mobile (36) qui ménage d'un côté un espace pour le passage du câble de liaison (C) et de l'autre côté un espace pour les conducteurs d'alimentation (33).

8. Dispositif selon la revendication 1, **caractérisé par le fait que** le câble de liaison (C) est connecté au module terminal (30) par un connecteur (41) présentant une partie femelle (42) et une partie mâle (43) soudée à un circuit imprimé (44), le module présentant un canal (30b) d'engagement de la partie femelle, la partie femelle et le canal étant pourvus de formes respectives (42a,30a) évitant la transmission des vibrations du connecteur au circuit imprimé.

## Claims

1. Automation device comprising a modular assembly associated with an automatic operation cell and comprising a main group (10A) of juxtaposed modules on a support associated with a main area of the cell, the main group including a control member (20) able to route control and command signals, a power supply module (21) able to distribute at least one power supply voltage (Uᵢₙ, Uₒᵤₜ) for automatic control members, a number of functional modules (22) with, between the modules, a first link (SB) which routes the control signals and at least one power supply voltage for the modules and a second link (PB) which routes the power supply voltages for the automatic control members, and a terminal module (30),
***characterized in that**:*
- the device comprises at least one secondary group of modules (10B) associated with a secondary area of the cell and having a head module (24), and a first and a second links (SB, PB) extending those of the main group (10A),
- a link cable (C) associated with the first link (SB) and able to immunely route the control and command signals and a power supply voltage (V1) for the modules, the cable being connected to the terminal module (30) of the main group and to the head module (24) of the secondary group (10B).

2. Device according to Claim 1, **characterized in that** the main group (10A) comprises at least one power supply module (23) for the electronic circuits of the modules situated downstream, this module having voltage converter means (23A) able to restore to its nominal level a low power supply voltage (V2) of the first link (SB) from a high power supply voltage (V1) of this same link.

3. Device according to Claim 1 or 2, **characterized in that** the head module (24) of the secondary group (10B) has voltage converter means (24a) able to restore to its nominal level a lower power supply voltage (V2) of the first link (SB) from a high power supply voltage (V1) of this same link.

4. Device according to Claim 1, **characterized in that** a power supply module (21) connected to an external voltage source and able to distribute at least one power supply voltage (Uᵢₙ, Uₒᵤₜ) for the automatic control members is positioned adjacent to the heat module (24) of the secondary group (10B).

5. Device according to Claim 1, **characterized in that** the terminal module (30) of the main group (10A) makes it possible to apply, by means of at least one power supply conductor (33) separate from the cable (C), the voltages of the second bus link (PB) to automatic control members (15) not managed by the first bus link (SB).

6. Device according to Claim 5, **characterized in that** the terminal module (30) of the main group (10A) has a terminal block (31) provided with terminals (32) for the power supply conductors (33) of the automatic control members and partitioned to separate the link cable (C) from the conductors (33).

7. Device according to Claim 6, **characterized in that** the terminal block (31) is partitioned by means of a moving flap (36) which provides, on one side, a space for the passage of the link cable (C) and, on the other side, a space for the power supply conductors (33).

8. Device according to Claim 1, **characterized in that** the link cable (C) is connected to the terminal module (30) by a connector (41) having a female portion (42) and a male portion (43) soldered to a printed circuit (44), the module having a channel (30b) for engaging the female portion, the female portion and the channel being provided with respective shapes (42a, 30a) avoiding the transmission of the vibrations from the connector to the printed circuit.

## Patentansprüche

1. Automatisierungsvorrichtung, die eine modulare Einheit enthält, welche einer Automatisierungsinsel zugeordnet ist und eine Hauptgruppe (10A) von auf einem einer Hauptzone der Insel zugeordneten Träger nebeneinander angeordneten Modulen enthält, wobei die Hauptgruppe ein Steuerorgan (20), das Steuerungssignale befördern kann, ein Versorgungsmodul (21), das mindestens eine Versorgungsspannung (Uᵢₙ, Uₒᵤₜ) an Automatisierungsorgane verteilen kann, mehrere Funktionsmodule (22), mit zwischen den Modulen einer ersten Verbindung (SB), die die Steuerungssignale und mindestens eine Versorgungsspannung der Module befördert, und einer zweiten Verbindung (PB), die die Versorgungsspannungen der Automatisierungsorgane befördert, und ein Endmodul (30) aufweist,
**dadurch gekennzeichnet, dass**:
- die Vorrichtung mindestens eine Sekundärgruppe (10B) von Modulen enthält, die einer Sekundärzone der Insel zugeordnet ist und ein Kopfmodul (24) sowie eine erste und eine zweite Verbindung (SB, PB) aufweist, die diejenigen der Hauptgruppe (10A) verlängern,
- ein Verbindungskabel (C), das der ersten Verbindung (SB) zugeordnet ist und die Steuerungssignale und eine Versorgungsspannung (V1) der Module störungsfest befördern kann, wobei das Kabel mit dem Endmodul (30) der Hauptgruppe und mit dem Kopfmodul (24) der Sekundärgruppe (10B) verbunden ist.

2. Vorrichtung nach Anspruch 1, **dadurch gekennzeichnet, dass** die Hauptgruppe (10A) mindestens ein Versorgungsmodul (23) der elektronischen Schaltkreise der hinten angeordneten Module enthält, wobei dieses Modul Spannungswandlereinrichtungen (23a) besitzt, die eine niedrige Versorgungsspannung (V2) der ersten Verbindung (SB) ausgehend von einer hohen Versorgungsspannung (V1) dieser gleichen Verbindung wieder auf ihren Nennpegel bringen können.

3. Vorrichtung nach Anspruch 1 oder 2, **dadurch gekennzeichnet, dass** das Kopfmodul (24) der Sekundärgruppe (10B) Spannungswandlereinrichtungen (24a) besitzt, die eine niedrige Versorgungsspannung (V2) der ersten Verbindung (SB) ausgehend von einer hohen Versorgungsspannung (V1) dieser gleichen Verbindung wieder auf ihren Nennpegel bringen können.

4. Vorrichtung nach Anspruch 1, **dadurch gekennzeichnet, dass** ein mit einer externen Spannungsquelle verbundenes und zur Verteilung mindestens einer Versorgungsspannung (Uᵢₙ, Uₒᵤₜ) für Automatisierungsorgane fähiges Versorgungsmodul (21) dem Kopfmodul (24) der Sekundärgruppe (10B) benachbart angeordnet ist.

5. Vorrichtung nach Anspruch 1, **dadurch gekennzeichnet, dass** das Endmodul (30) der Hauptgruppe (10A) es ermöglicht, mittels mindestens eines vom Kabel (C) unterschiedlichen Versorgungsleiters (33) die Spannungen der zweiten Busverbindung (PB) an Automatisierungsorgane (15) anzulegen, die nicht von der ersten Busverbindung (SB) verwaltet werden.

6. Vorrichtung nach Anspruch 5, **dadurch gekennzeichnet, dass** das Endmodul (30) der Hauptgruppe (10A) einen Anschlussblock (31) aufweist, der mit Anschlussklemmen (32) für die Versorgungsleiter (33) der Automatisierungsorgane versehen und unterteilt ist, um das Verbindungskabel (C) von den Leitern (33) zu trennen.

7. Vorrichtung nach Anspruch 6, **dadurch gekennzeichnet, dass** der Anschlussblock (31) mittels einer beweglichen Klappe (36) unterteilt ist, die auf der einen Seite einen Raum für den Durchgang des Verbindungskabels (C) und auf der anderen Seite einen Raum für die Versorgungsleiter (33) bildet.

8. Vorrichtung nach Anspruch 1, **dadurch gekennzeichnet, dass** das Verbindungskabel (C) mit dem Endmodul (30) über einen Steckverbinder (41) verbunden wird, der einen Buchsenteil (42) und einen an eine gedruckte Schaltung (44) geschweißten Steckerteil (43) aufweist, wobei das Modul einen Einführkanal (30b) des Buchsenteils aufweist, wobei der Buchsenteil und der Kanal mit Formen (42a, 30a) versehen sind, die die Übertragung von Schwingungen vom Steckverbinder zur gedruckten Schaltung verhindern.
